Europäisches Patentamt

European Patent Office

Office européen des brevets

(11) Publication number: **0 083 447**
**B1**

(12) **EUROPEAN PATENT SPECIFICATION**

(45) Date of publication of patent specification: 26.04.89

(21) Application number: 82112060.7

(22) Date of filing: 28.12.82

(51) Int. Cl.⁴: **H 01 L 29/08,** H 01 L 29/10, H 01 L 29/88, H 01 L 21/265

(54) Triple diffused short channel device structure.

(30) Priority: 30.12.81 US 335608

(43) Date of publication of application:
13.07.83 Bulletin 83/28

(45) Publication of the grant of the patent:
26.04.89 Bulletin 89/17

(84) Designated Contracting States:
DE FR GB NL

(56) References cited:
FR-A-2 379 168
FR-A-2 464 536
US-A-3 959 025
US-A-4 198 250
IEEE TRANSACTIONS ON ELECTRON
DEVICES, vol. ED-26, no. 4, April 1979, pages
430-435, New York, US; I. OHKURA et al.:
"Electrical characteristics of a DSA MOS
transistor with a fine structure"

(73) Proprietor: THOMSON COMPONENTS-
MOSTEK CORPORATION
1310 Electronics Drive
Carrollton Texas 75006 (US)

(72) Inventor: Han, Yu-Pin
7701 Scotia Drive
Dallas Texas 75248 (US)
Inventor: Chan, Tsiu Chiu
1633 Camero Carrollton
Dallas Texas 75006 (US)

(74) Representative: Rinuy, Santarelli
14, avenue de la Grande Armée
F-75017 Paris (FR)

EP 0 083 447 B1

Courier Press, Leamington Spa, England.

## Description

Technical field

The present invention relates to a metal oxide semiconductor device and a process for fabricating such a device, more particularly to field effect transistors used in large scale integrated circuits and a process for fabricating such devices.

Background of the invention

Process and device technology have been developed to improve the performance of large scale integrated circuits. Increasing the density of MOS devices and LSI circuits result in improved higher speeds of operation.

Nonplanar-type devices have been proposed for such high performance LSI circuits, including a nonplanar diffusion self-aligned (DSA) MOS transistor and a VMOS transistor. These two nonplanar devices have three dimensional configurations, which increase the packing density of the LSI. However, the process for fabricating such devices include an epitaxial and a V-groove process which require a larger number of fabrication steps than that of the planar-type devices.

Planar type devices utilized for high performance LSI circuits have generally involved scaling down the physical dimensions of the transistor. The short channel lengths involved in such scaled down transistors have involved limitations from the electrical characteristics present in such scaled down devices. The limitations on such short channel devices have been the following: limited drain voltage, threshold voltage ($V_T$) falloff, and impact ionization in the drain pinchoff region. The drain voltage is limited by punch-through voltage decrease, snap back and gate field plated P—N junction avalanche breakdown. The threshold voltage falloff is limited by the drain field induced barrier lowering and the drain and source junction doping profile and substrate doping concentration. The impact ionization in the drain pinchoff region leads to hot-electron injection into the gate oxide and the substrate electron current due to secondary impact ionization.

There have been several approaches in device structures and fabrication technologies to remove some of these limitations. One fabrication technology uses a high resistivity substrate and double channel implants, where a deep implant is used to increase the punch-through voltage and a shallow implant is used to control $V_T$. The second approach has been a diffusion self-aligned MOS transistor or a double-diffused MOS transistor. This device causes double diffusion of P-type impurities from the same diffusion window, the process yields good short channel $V_T$ falloff and a source-drain breakdown control. Yet a third approach has been a lightly doped drain-source (LDD) process and a quadruply self-aligned (QSA) process. The LDD structure introduces narrow, self-aligned N— regions between the channel and the N+ source-drain diffusions of an IGFET to spread the high field at the drain pinchoff region and thus reduce the maximum field intensity. The QSA MOS device includes four mutually self-aligned areas: a narrow polysilicon gate, shallow-source/drain to eliminate short-channel effects, deep junctions for high conductance, and specific contacts to afford efficient metal innerconnection.

A need has thus arisen to develop an improved process to produce short one to two micron channel length devices without short channel $V_T$ falloff and reasonable source-drain operating voltage support.

Summary of the invention

The present invention provides an improved short one to two micrometer channel length metal oxide semiconductor device, and a process for manufacturing the same, as defined in respective independent claims hereafter. The improvements reduce the characteristic problems associated with short channel devices having a channel length of one to two microns.

IEEE Transactions on Electronics Devices, Vol. ED-26, No. 4, April 1979, pages 430—435, disclose a symmetrical DSA MOS transistor, the features of which are reflected in the introducing part of claim 1.

The process includes diffusing a very light concentration of P type material, such as boron, to create a very lightly doped P— — substrate region. The source and drain regions are formed from the diffusion of a high concentration of N—type material, such as arsenic, to create an N+ region for the source and drain. A latter concentration of N-type material is diffused in the region between the N+ material and the gate to create an N— region to reduce punch through. A high concentration of P-type material, such as boron, is implanted between the gate and source and drain areas to form P regions to control the drain field and drain bias, such that the fields can be limited to the drains lightly doped area. A lighter concentration of P-type material is implanted beneath the gate to form a P— region to control the $V_T$ falloff for short channel devices.

The concentration of boron at the source-gate area is similar to that in the double diffusion of P type impurities ($D^2$) referred to above, but the triple diffused ($D^3$) process of the present invention does not require the high temperature drive because of the shallow and lightly doped N-source-drain implant. The triple diffusion process of the present invention is a highly localized process in which the special features are in effect independently adjustable. The N+ junction depth ($X_j$) can be driven independently. In addition, the N— junction depth ($X_j$) and length are adjustable according to device specifications through the undercutting of the polysilicon gate.

Brief description of the drawings

For a more complete understanding of the present invention of the advantages and features thereof, reference is now made to the accompanying Detailed Description taken in conjunction with the following figures in which:

Figure 1 is a cross sectional view of a transistor device structure of the present invention;

Figure 2 is a profile of the device structure of Figure 1 taken along the lines 2—2 in Figure 1;

Figure 3 illustrates the shallow boron implant step in the process;

Figure 4 illustrates the device structure after the process steps of polygate photo resist patterning, plasma etching of the oxide and polysilicon, and undercutting of the polysilicon;

Figure 5 illustrates the diffusion of arsenic impurity material to the device structure;

Figure 6 illustrates a light diffusion of arsenic material and boron implant; and

Figure 7 illustrates the process of driving the arsenic and boron impurities into the substrate and oxidizing the surface.

Detailed description

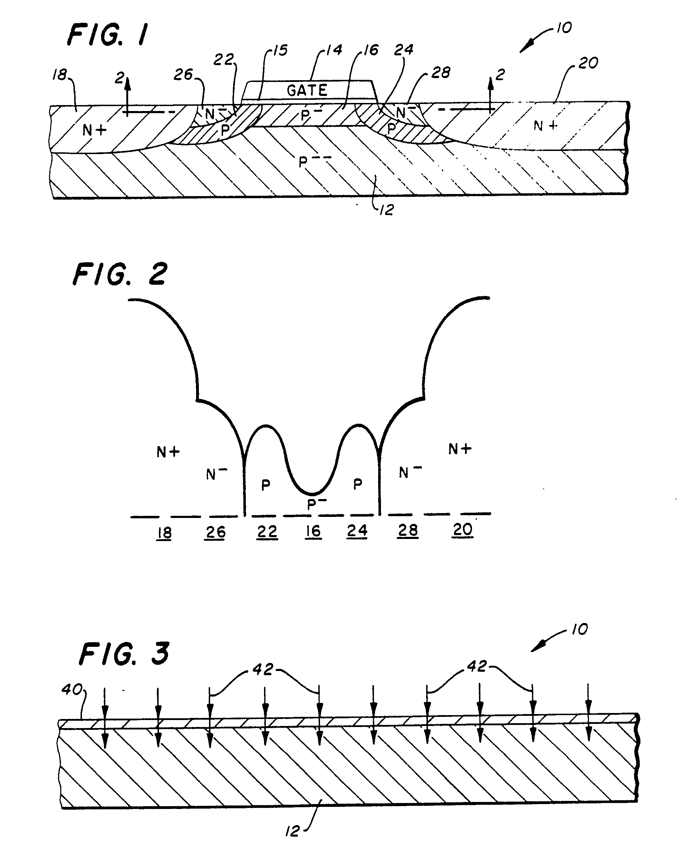

Figure 1 illustrates one FET of a large scale integrated circuit fabricated in accordance with the process of the present invention, the FET device being generally identified by the reference numeral 10. The substrate region 12 of the device is a silicon material lightly doped with a P-type material, such as boron, and designated as P— — region. A gate 14 is separated from the silicon substrate 12 by a layer of silicon dioxide 15. A channel region 16 above the P— — region 12 and below the gate 14 is slightly heavier doped with a P-type material than substrate 12 and is designated as a P— region. A source 18 and drain 10 are formed by heavily doping a region of the substrate 12 on opposite sides of the gate 14 with an N-type material and designated as an N+ region.

Two first regions 22 and 24 are doped with P-type material in a greater concentration than channel region 16, and designated as a P region, extending from beneath the edges of the gate 14 downwardly to the boundary of the N+ source 18 and drain 20. The P-type material implanted in regions 22 and 24 supports the shallow punchthrough and $V_T$ falloff.

Two second regions 26 and 28 are lightly doped with an N-type material, such as aresnic, to create shallow N— regions between the gate 14 and the N+ source 18 and drain 20. The N— regions 26 and 28 reduce the depletion at the gate 14-drain 20 region and also reduce the overlap of the gate and drain, enhancing the effect of the double diffused P-type material in regions 22 and 24.

Figure 2 illustrates a profile of the concentration of N and P-type impurities implanted into the device 10, taken along the line 2—2 of Figure 1. The heaviest implantation of N-type material is found in the source and drain regions 18 and 20. The regions 26 and 28 are lightly doped with an N-type material to form N— regions between the N+ regions 18 and 20 and the edges of the gate region 14. The profile of the impurity concentration in the channel region, located directly beneath the gate 14 includes the P-channel region 16 beneath the center of the gate 14 and extending to regions 22 and 24 on either side, which regions contain a greater concentration of P-type material.

The process of manufacturing the field effect transistor 10 begins with oxidizing the upper surface of the silicon substrate 12. As illustrated in Figure 3, a layer of silicon dioxide 40, approximately 30 nm (300 angstroms) thick, is grown atop the substrate 12. A first implantation 42 of a P-type material, such as boron, occurs after the formation of the silicon dioxide layer 40. The boron implantation occurs at an intensity of about $2 \times 10^4$ boron ions/cm$^2$ at an energy level of 40 Kev in accordance with known ion implantation techniques. The first diffusion 42 of P-type material supports the shallow punchthrough and adjustment of the $V_T$ falloff.

The next process steps for manufacturing the FET 10 is beginning of the formation of the polysilicon gate 14 with the deposition of a layer of polysilicon material with a depth of about 500 nm (5,000 angstroms), using known deposition techniques. The layer of polysilicon material is next implanted with phosphorous, an N-type material. The layer of polysilicon material implanted with phosphorous is then oxidized with a layer of silicon dioxide approximately 150 nm (1,500 angstroms) in thickness.

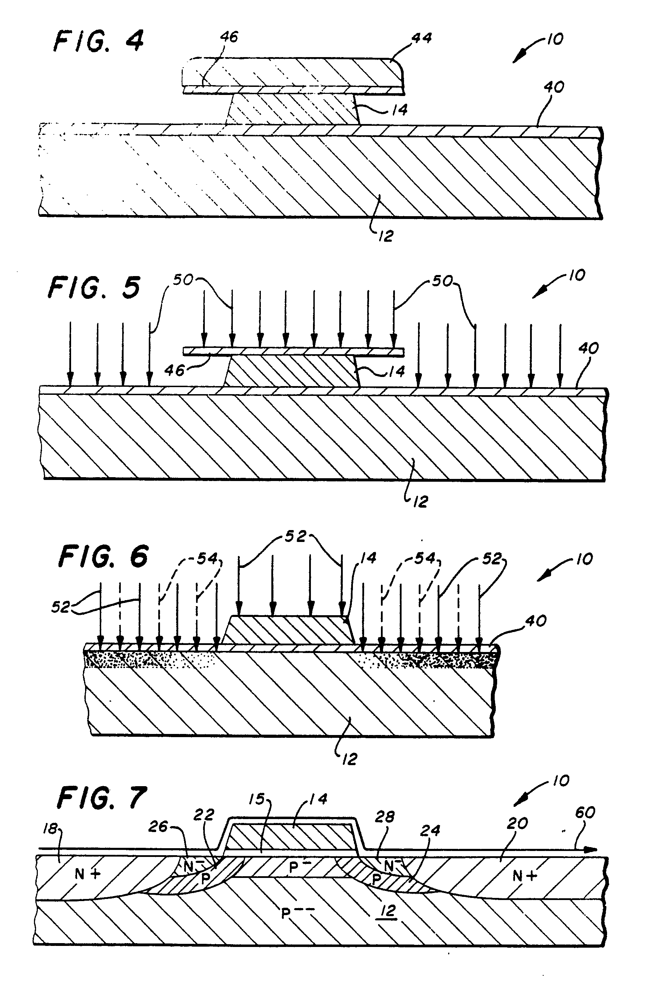

Figure 4 illustrates the next three steps in the process of manufacturing the FET device 10. The first step is the covering of the polysilicon gate 14 with a layer of photoresist 44, followed by a wet etching of the polysilicon oxide layer 46 and the plasma etching of the layer of polysilicon of gate 14 beneath it. The next step is the undercutting of the polysilicon layer of gate 14 beneath the polyoxide layer 46. The distance the polysilicon layer is undercut allows for the adjustment of the N— regions 26 and 28 (Figure 1). The photoresist layer 44 is then stripped, using conventional techniques.

Figure 5 illustrates the implantation step 50 of an N-type material, such as arsenic, for forming the heavily doped N+ regions 18 and 20 for the source and drain of the FET 10. The energy of the arsenic ion is selected so as to penetrate only through the portions not covered by the polysilicon oxide layer 46. An intensity of about $2 \times 10^{16}$ arsenic ions/cm$^2$ with an energy level of 60 Kev is selected, using known ion implantation techniques. Following the implantation of the arsenic, the silicon dioxide layer 46 is etched away.

Figure 6 illustrates an implantation step 52 of N-type material, such as arsenic, as indicated by the solid arrows, for forming regions 26 and 28. The intensity of the arsenic ions is $1 \times 10^{13}$ arsenic ions/cm$^2$ with an energy level of 60 Kev. The implantation step 52 provides a lightly doped area forming the N— region 26 and 28, which are between gate region 14, and a heavier N+ region 18 and 20 for the source and drain. A second implantation 54 of P-type material, such as boron, is indicated by the dashed arrow in Figure 6. An intensity of about $5 \times 10^{12}$ boron ions/cm$^2$ with an energy level of 35 Kev is used in accordance with known ion implantation techniques. The triple diffusion process is the implantation step 50 to form N+ regions 18 and 20, the implantation step 52 to form N− regions 26 and 28, and the implantation step 54 to form the P regions 22 and 24.

Figure 7 illustrates the next process step of thermally oxidizing the upper layer of the FET 10, and the oxidation process drives the boron $D^2$ implantation to greater depths within the substrate 12. Following a metalization process to form the contacts, the metal oxide semiconductor FET transistor structure 10 has been constructed.

The process described above for manufacturing the metal oxide semiconductor FET 10 has a number of advantages over previous device processes. The principle advantage is the individual adjustment of special features of the device 10. The substrate 12 with its light doped P− − region has high resistivity. The N+ regions of the source 18 and drain 20 can be driven independently to adjust the penetration of the N+ region into the substrate. The double diffusion of the boron does not need as long a drive time as in previous processes, since the N− region is a lightly doped region of N-type material, and the double diffused boron can be driven at the same time the N− material is driven. The N− regions at the edge of gate 14 are adjustable according to manufacturer's specifications. As indicated above, the N− region can be controlled by the undercutting of the polysilicon gate 14. Finally, there is a small overlap capacitance between the polysilicon gate 14 and the source/drain in the semiconductor device 10 made in accordance with the present invention.

In one semiconductor device 10 manufactured in accordance with the present invention, the gate 14 had a length of approximately 1.5 microns, the source and drain N+ region had a $X_j$ dimension of .7 microns, the N− regions have a $X_j$ dimension of approximately 1.5 microns, and the P-type regions 22 and 24 had a thickness of approximately .3 microns.

Although a preferred embodiment of the invention has been illustrated in the accompanying Drawings and described in the foregoing Detailed Description, it will be understood that the invention is not limited to the embodiments disclosed herein, but they are capable of numerous rearrangements, modifications and substitution without departing from the scope of the invention as defined in the appended claims.

## Claims

1. A short one to two micrometer channel length metal oxide semiconductor transistor device comprising:
    a semiconductor substrate (12) of relatively high resistivity and of one conductivity type,
    an insulating oxide layer (15) overlying the silicon substrate,
    a gate electrode (14) overlying the oxide layer and defining a gate region in the substrate,
    source (18) and drain (20) regions of relatively low resistivity and of the other conductivity type spaced apart from the gate region on opposite sides thereof,
    two first regions (22, 24) for supporting shallow punch-through and controlling threshold voltage fall-off, two second regions (26, 28) for reducing the depletion at the gate-drain region, the latter regions being of the other conductivity type, more lightly doped than the source and drain regions and including surface portions disposed between the source and drain regions and respective edges of the gate region,
    the first regions (22, 24) being of the one conductivity type, relatively more highly doped than the substrate, including surface portions underlying the gate electrode and defining respective edges of the gate region, and extending laterally. underneath the respective second regions to the source and drain regions,
    characterized in that the portion (16) of the gate region between the surface portions of the two first regions is relatively more heavily doped than the substrate but is relatively more lightly doped than the surface portions of the second regions, and has the same conductivity type as the substrate.

2. A process for manufacturing short one to two micrometer channel length metal oxide semiconductor transistor device comprising the following steps in succession:
    providing a semiconductor substrate (12) of a first conductivity type,
    forming a first insulating layer (40) of silicon dioxide on an active surface of the substrate,
    implanting (42) ions of a fist conductivity type into said substrate through the first insulating layer (40),
    depositing a layer (14) of polysilicon on said first insulating layer (40),
    implanting ions of a second conductivity type into said polysilicon layer (14),
    growing a second layer (46) of silicon dioxide, said silicon dioxide layer being grown over said polysilicon layer (14),
    placing a photoresistive mask (44) over said second silicon dioxide layer (14) for forming a gate of the semiconductor device,
    etching a predetermined portion of said second silicon dioxide layer not covered by said photoresist mask to expose said polysilicon layer (14) and plasma etching said exposed polysilicon layer to leave a double layer of silicon dioxide and polysilicon longer than the gate,
    removing a predetermined portion of said polysilicon layer underneath said second silicon dioxide layer to realise the polysilicon gate (14),
    stripping said photoresist mask from said second silicon dioxide layer leaving the second silicon dioxide layer overhanging said polysilicon gate (14),
    implanting (50) ions of the second conductivity type by using said second silicon dioxide layer as mask for forming heavily doped source and drain regions (18, 20),
    removing said second silicon dioxide layer,

implanting (52) ions of said second conductivity type using the polysilicon gate (14) as a mask to form lightly doped regions (26, 28) between the gate region and the heavily doped regions,

implanting (54) ions of said first conductivity type using the polysilicon gate (14) as a mask for forming regions (22, 24) more heavily doped than the substrate under the polysilicon gate (14) and extending laterally underneath the lightly doped regions (26, 28) to the source and drain regions,

diffusing the implanted ions into said substrate (12), and oxidising the active surface of said substrate including said polysilicon gate.

3. A process as claimed in claim 2, characterized in that the implanted ions of the first conductivity type are boron ions, and the implanted ions of the second conductivity type are arsenic ions.

**Patentansprüche**

1. Metalloxid-Halbleitertransistoreinrichtung mit kurzer Kanallänge von einem bis zwei Mikrometern, bestehend aus:

einem Halbleitersubstrat (12) mit relativ hohem spezifischen Widerstand und von einem Leitfähigkeitstyp,

eine isolierende Oxidschicht (15), welche über dem Halbleitersubstrat (12) angeordnet ist,

einer über der Oxidschicht liegenden und einen Gatterbereich in dem Substrat definierenden Gatterelektrode (14),

einem Quellen- (18) und einem Senkenbereich (20) mit vergleichsweise niedrigem spezifischen Widerstand und von einem anderen Leitfähigkeitstyp, die an entgegengesetzten Seiten des Gatterbereichs, von diesem beabstandet, angeordnet sind,

zwei ersten Bereichen (22, 24) zum Unterstützen eines flachen Durchgreifens (punched-through) und zum Steuern eines Schwellenspannungsabfalls, zwei zweiten Bereichen (26, 28) zum Vermindern der Abreicherung an dem Gatter-Senken-Bereich, wobei die letzteren Bereiche vom anderen Leitfähigkeitstyp sind, geringer dotiert sind als der Quellen- und den Senkenbereich und Oberflächenabschnitte einschließen, die zwischen dem Quellen- und dem Senkenbereich und den entsprechenden Kanten des Gatterbereichs liegen, wobei die ersten Bereiche (22, 24) vom einen Leitfähigkeitstyp dem Substrat einschließlich den unter der Gatterelektrode liegenden und die entsprechenden Kanten des Gatterbereichs bildenden Oberflächenabschnitten verhältnismäßig hoch dotiert sind, dadurch gekennzeichnet, daß der Abschnitt (16) des Gatterbereichs zwischen den Oberflächenabschnitten der zwei ersten Bereiche vergleichsweise höher dotiert ist als die Oberflächenabschnitte der zweiten Bereiche und denselben Leitfähigkeitstyp aufweist wie das Substrat.

2. Verfahren zum Herstellen einer Metalloxid-Halbleitertransistoreinrichtung mit kurzer Kanallänge von einem bis zwei Mikrometern, mit den nachstehenden aufeinander folgenden Verfahrensschritten:

Bereitstellen eines Halbleitersubstrats (12) von einem ersten Leitfähigkeitstyp,

Bilden einer Erstisolierschicht (40) aus Siliziumdioxid an einer aktiven Oberfläche des Substrats, Einbauen (42) von Ionen eines ersten Leitfähigkeitstyps in das Substrat durch die erste Isolierschicht,

Niederschlagen einer Schicht (14) aus Polysilizium auf der ersten Isolierschicht (40),

Dotieren von Ionen des zweiten Leitfähigkeitstyps in die Polysiliziumschicht (14), und Aufwachsen einer zweiten Schicht (26) aus Siliziumoxid, wobei diese Siliziumoxidschicht über die Polysiliziumschicht (14) aufwächst,

Aufbringen einer Fotoresist-Maske (44) über der zweiten Siliziumoxidschicht (46) zur Bildung eines Gatters der Halbleitereinrichtung,

Ätzen eines vorbestimmten Teils der zweiten Siliziumdioxidschicht, der nicht von der Fotoresist-Maske abgedeckt ist, zum Freisetzen der Polysiliziumschicht (14) und Plasma-Ätzen der freigesetzten Polysiliziumschicht zum Belassen einer Doppelschicht aus Siliziumdioxid und Polysilizium, die länger als das Gatter ist,

Entfernen eines vorbestimmten Teils der Polysiliziumschicht unterhalb der zweiten Siliziumdioxidschicht zur Schaffung des Polysiliziumgatters (14),

Abstreifen der fotoresistiven Maske der zweiten Siliziumdioxidschicht unter Belassung der zweiten Siliziumdioxidschicht in das Polysiliziumgatter (14) überhängendem Zustand,

Dotieren (50) von Ionen des zweiten Leitfähigkeitstyps unter Verwendung der zweiten Siliziumdioxidschicht als Maske zum Bilden hoch dotierter Quellen- und Abflußbereiche (18, 20),

Entfernen der zweiten Siliziumdioxidschicht,

Einbauen (52) von Ionen des zweiten Leitfähigkeitstyps unter Verwendung des Polysiliziumgatters (14) als Maske zur Bildung gering dotierter Bereiche (26, 28) zwischen dem Gatterbereich und den hochdotierten Bereichen,

Dotieren (54) von Ionen des ersten Leitfähigkeitstyps unter Verwendung des Polysiliziumgatters (14) als eine Maske zur Bildung von Abschnitten (22, 24), die höher dotiert sind als das Substrat unterhalb des Polysiliziumgatters (14) und sich seitlich unterhalb der leicht dotierten Abschnitte (26, 28) zum Quellen- und zum Senkenbereich erstrecken,

Eindiffundieren der eingebauten Ionen in das Substrat (12) und Oxidieren der aktiven Oberfläche des Substrats einschließlich dem Polysiliziumgatter.

3. Verfahren nach Anspruch 2, dadurch gekennzeichnet, daß die dotierten Ionen des ersten Leitfähigkeitstyps Bor-Ionen und die eingebauten Ionen des zweiten Leitfähigkeitstyps Arsen-Ionen sind.

**Revendications**

1. Un dispositif consistant en un transistor métaloxyde-semiconducteur à canal court, de 1 à 2 micromètres de longueur, comprenant:

un substrat semiconducteur (12) de résistivité relativement élevée et d'un premier type de conductivité,

une couche d'oxyde isolante (15) recouvrant le substrat en silicium,

une électrode de grille (14) recouvrant la couche d'oxyde et définissant une région de grille dans le substrat,

des régions de source (18) et de drain (20) de résistivité relativement faible et du second type de conductivité, espacées par rapport à la région de grille, de part et d'autre de celle-ci,

deux premières régions (22, 24) destinées à s'opposer au perçage à faible profondeur et à maîtriser la diminution de la tension de seuil, deux secondes régions (26, 28) destinées à réduire la désertion dans la région grille-drain, ces dernières régions ayant le second type de conductivité, étant plus faiblement dopées que les régions de source et de drain et comprenant des parties de surface qui sont disposées entre les régions de source et de drain et des bords respectifs de la région de grille,

les premières régions (22, 24) étant du premier type de conductivité, avec un dopage relativement plus élevé que celui du substrat, comprenant des parties de surface situées au-dessous de l'électrode de grille et définissant des bords respectifs de la région de grille, et s'étendant latéralement au-dessous des secondes régions respectives des régions de source et de drain,

caractérisé en ce que la partie (16) de la région de grille qui se trouve entre les parties surface des deux premières régions est relativement plus fortement dopée que le substrat, mais est relativement plus faiblement dopée que les parties de surface des secondes régions, et elle a le même type de conductivité que le substrat.

2. Un procédé de fabrication d'un dispositif consistant en un transistor métal-oxyde-semiconducteur à canal court, de un à deux micromètres de longueur, comprenant les étapes suivantes, en succession:

on fournit un substrat semiconducteur (12) d'un premier type de conductivité,

on forme une première couche isolante (40) de dioxyde de silicium sur une surface active du substrat,

on implante (42) des ions d'un premier type de conductivité dans le substrat, à travers la première couche isolante (40),

on dépose une couche (14) de silicium polycristallin sur la première couche isolante (40),

on implante dans la couche de silicium polycristallin (14) des ions d'un second type de conductivité,

on fait croître une seconde couche (46) de dioxyde de silicium, la croissance de cette couche de dioxyde de silicium ayant lieu sur la couche de silicium polycristallin (14),

on place un masque de résine photosensible (44) sur la seconde couche de dioxyde de silicium (14), pour former une grille du dispositif à semiconducteurs,

on enlève par gravure une partie prédéterminée de la seconde couche de dioxyde de silicium qui n'est pas recouverte par le masque de résine photosensible, pour mettre à nu la couche de silicium polycristallin (14), et on grave par plasma la couche de silicium polycristallin à nu, pour laisser une double couche de dioxyde de silicium et de silicium polycristallin, plus longue que la grille,

on enlève une partie prédéterminée de la couche de silicium polycristallin se trouvant au-dessous de la seconde couche de dioxyde de silicium, pour former la grille en silicium polycristallin (14),

on décape le masque de résine photosensible se trouvant sur la seconde couche de dioxyde de silicium, pour laisser la seconde couche de dioxyde de silicium en surplomb sur la grille en silicium polycristallin (14),

on implante (50) des ions du second type de conductivité, en utilisant comme masque la seconde couche de dioxyde de silicium, pour former des régions de source et de drain fortement dopées (18, 20),

on enlève la seconde couche de dioxyde de silicium,

on implante (52) des ions du second type de conductivité, en utilisant comme masque la grille en silicium polycristallin (14), pour former des régions faiblement dopées (26, 28) entre la région de grille et les régions fortement dopées,

on implante (54) des ions du premier type de conductivité, en utilisant comme masque la grille en silicium polycristallin (14), pour former des régions (22, 24) plus fortement dopées que le substrat, situées au-dessous de la grille en silicium polycristallin (14) et s'étendant latéralement au-dessous des régions faiblement dopées (26, 28), jusqu'aux régions de source et de drain,

on fait diffuser dans le substrat (12) les ions implantés, et on oxyde la surface active du substrat, y compris la grille en silicium polycristallin.

3. Un procédé selon la revendication 2, caractérisé en ce que les ions implantés du premier type de conductivité sont des ions bore, et les ions implantés du second type de conductivité sont des ions arsenic.

*FIG. 1*

*FIG. 2*

*FIG. 3*

FIG. 4

FIG. 5

FIG. 6

FIG. 7